# EUROPEAN PATENT SPECIFICATION

(11) **EP 4 033 871 B1**
(45) Date of publication and mention of the grant of the patent: **10.04.2024**
(21) Application number: 21461617.9
(22) Date of filing: 06.11.2021
(51) Int. Cl.: H05K 13/04, H05K 13/08

(54) **METHOD OF MOUNTING SUITABLE FOR POSITIONING THROUGH-HOLE COMPONENTS ON A PRINTED CIRCUIT BOARD PCB**
VERFAHREN ZUR MONTAGE ZUR POSITIONIERUNG VON KOMPONENTEN MIT DURCHGANGSLÖCHERN AUF EINER LEITERPLATTE (PCB)
PROCÉDÉ DE MONTAGE PERMETTANT DE POSITIONNER DES COMPOSANTS À TROU TRAVERSANT SUR UNE CARTE DE CIRCUIT IMPRIME (PCB)

(43) Date of publication of application: 27.07.2022
(73) Proprietor: Fitech sp. z o.o., 34-200 Sucha Beskidzka (PL)
(72) Inventor: BOREK, Pawel, 34-200 Sucha Beskidzka (PL); GRZADZIEL, Michal, 34-200 Sucha Beskidzka (PL); HUBCZAK, Mariusz, 34-323 Slemien (PL); MISTRZYK, Piotr, 26-200 Konskie (PL); PALECZNY, Pawel, 34-210 Zembrzyce (PL); POREBSKI, Lukasz, 34-200 Sucha Beskidzka (PL); SZEWCZYK, Dominik, 34-340 Jelesnia (PL); TRZNADEL, Miroslaw, 34-200 Sucha Beskidzka (PL); PYCLIK, Krzysztof, 34-300 Zywiec (PL)
(74) Representative: AOMB Polska Sp. z.o.o.

(56) References cited:
- US-A- 4 833 776
- US-A- 4 964 211

## Description

### Field of the invention

The invention provides a method of mounting, suitable for positioning through-hole components on a printed circuit board PCB, and in particular for embedding through-hole electronics elements such as e.g. transistors, varistors, relays, capacitors on a board.

### Background of the invention

In the prior art, methods for mounting elements are known which are carried out by robots with the use of computer software.

Document CN 108766894 A discloses a method for mounting a chip and a system for guiding of vision of a robot. A second industrial camera is additionally positioned within each PCB positioning area and within a chip positioning area; the robot is provided for absorbing chips that may be moved to stations of second industrial cameras; photographs of the absorbed chips are taken, and the angular difference between the included angle of the chip mounting surface and the horizontal axis so that the terminal actuator rotates in a P3 position within the angular difference, angular compensation is carried out, and the compensation is effected on X-axis and on Y-axis, a slip error is generated when chips are absorbed or in a transfer process upon enhanced chip absorption area and mounting accuracy enhancement, since a six-axes robot has a higher degree of freedom and elasticity, mounting of chips is effected within the workpieces such as cavities and flexible production is obtained; then on the robot arms the first industrial cameras are placed and the robot is easier to be moved and thus the position-based visual control method is more flexible and has a broader scope of application.

Document CN 109454638 A provides a robot grasping system based on visual guidance. The robot grasping system comprises a CCD camera, a lens, a light source, an industrial control computer and an industrial control robot, the CCD camera being an industrial camera and communicating with the computer via gigabit Ethernet; the CCD camera being installed over a belt conveyor flight. The lens is a fixed-focus lens. The source of light is an annular LED light source. Image information captured by the CCD camera are received and converted into robot control signals to control the actual final robot position when recognition of the workpiece by means of an image processing algorithm is completed. The industrial control robot is provided with six rotational joints driven by an alternate current servomotor and is arranged for grasping operation in a production line. The robot grasping system has a higher accuracy and meets industrial-scale production requirements; the robot grasping system greatly contributing to enhancement of the automatization degree of the production line.

Document CN 103706568 A discloses a system and method for robotized sorting based on machine vision. The system comprises a CCD digital camera, a camera lens, a light source, a six-axes articulated robot main body, an electric control box and a vacuum cup. The CCD digital camera is connected to the industrial computer by means of a switch. The robot main body along with the six-axes articulated joint is connected to the electric control box. The electric control box has access to the switch. The vacuum cup is rigidly attached to the tail end of the six-axes robot main body along with the articulated joint. The camera is arranged to take photographs of the object being sorted, collecting data and transmitting data to an industrial computer by means of a switch. The industrial computer is provided for processing captured photographs of the object to be sorted, performing precise positioning and then outputting a control signal to the electric control box by means of the switch. The electric control box is arranged to control the six-axes articulation joint main body of the robot in order to carry out desired sorting processes according to the received control signal.

Document US4833776A1 discloses a tactile retrieval and insertion and method for electronic components in through-hole printed circuit boards. The electronic component retrieval and insertion apparatus for printed circuit boards is a tactile and displacement monitoring device for the retrieval from a source and insertion of electronic components into a through-hole PCB utilizing force and displacement sensors on extendable fingers adjustable for a multitude of shapes such that excessive force to the component and PCB can be avoided and the final position of the inserted component can be checked to verify proper seating.

Document US4964211A1 discloses a parts assembling apparatus for assembling an electronic part onto a printed circuit board by inserting leg portions such as lead pins of the part into the assembling holes formed in the board comprises a movable arm, holding mechanism, force sensor and discrminating device. A part is held at a preset position by the holding mechanism which is vertically reciprocated by the movable arm to the part assembling position over the board. The reaction force from the board which acts on the holding mechanism is detected by the force sensor when the part is assembled. On the basis of the sensor output, the discriminating device determines whether the lead pins have been correctly inserted into the part assembling holes of the board or not.

### Summary of the invention

It is the objective of the invention to provide a method that enables automatization of time-consuming process of manual forming and mounting electronic through-hole elements, by means of a robot arm with an algorithm that recognizes the place at which an element is positioned.

The method of mounting, suitable for positioning components on a printed circuit board PCB, with the use of an industrial robot comprising a force and/or a moment sensor as well as means for grasping and transporting a component, comprises the steps of:
a. grabbing a component,
b. transporting the component to a predetermined starting position,
c. taring the force and/or moment sensor,
d. transporting the component in the Z-axis, meant as a height over the board surface, towards the board, until the component contacts the board surface,
e. actuating a regulator with determined parameters,
f. transferring to the regulator, when output data are stabilized, a signal from the means for grasping and transporting of the industrial robot as a Z-axis offset,
   if the Z-axis offset is greater than or equal to a preset parameter
g. releasing the component from the means for grasping and transporting of the industrial robot and establishing the current position of the component as a starting point,
   if the Z-axis offset is less than a preset parameter
h. moving the component starting from the current position point,
i. arresting movement of the component when the force and/or moment sensor detects an opening edge in the board,
j. moving the component away from the opening edge based on the data from the force and/or moment sensor while leaving the component inside the opening,
k. repeating steps g.-j, while a change in the component movement is executed. characterised in that
   if the Z-axis offset is less than a preset parameter
   the moment when an opening edge is detected occurs as appearance of a value of the force resultant from Fx and Fy forces above a preset maximum horizontal force,
   wherein at the moment when an opening edge is detected the component is moved away in step j according to the direction of the force resultant from Fx and Fy forces to bring the value of the force resultant from Fx and Fy forces to a value below a preset minimum horizontal force value.

Preferably, step k is carried out if a predetermined maximum duration time or opening search area are not exceeded.

Preferably, before step a the following steps are performed:
m. transporting the component to a predetermined position with intentionally imposed X-axis and Y-axis offsets so as to prevent the component enter mounting openings,
n. taring the force and/or moment sensor,
o. tri-state Z-axis adjustment until Fz force is stabilized within a preset range,
p. recording the Z-axis starting position which position means detection of appropriate component height,
r. selecting regulator parameters,
s. actuating the regulator with determined parameters, the regulator output being transmitted as a Z-axis offset, while the X-axis and Y-axis offsets applied in the initial step being turned off,
t. recording the X-axis and Y-axis positions and the Z-axis offset, if the Z offset calculated by the regulator is greater than or equal to a preset percent value and passing to step a,
u. actuating opening search algorithm if the Z offset calculated by the regulator is less than the preset percent value,
wherein the opening search algorithm comprises the steps of:
u1. moving the component if the Z-axis offset is less than a preset parameter, along a predetermined path, beginning from the current position point.
u2. arresting movement of the component, when the force and/or moment sensor detects an opening edge in the board,
u3. moving the component away from the opening edge based on the data from the force and/or moment sensor,
u4. changing the component movement direction and repeating steps u1-u4.

Preferably, step u4 is carried out if a predetermined maximum duration time or opening search area are not exceeded, steps m-u are repeated.

Preferably, the regulator parameters are the proportional, integrating and differentiating parts set-ups.

Preferably, selection of the regulator parameters in step r is performed by Ziegler/Nichols oscillation method.

Preferably, the predetermined path along which the component is moving, has a spiral shape, preferably a square spiral shape.

Preferably, the depth at which the component is embedded in the board is calculated based on the rigidity of the board and the element insertion length.

Preferably, the component is positioned in a greater number of openings.

A computer program comprising instructions that cause, when the program is executed by the computer, that the computer executes the method according to the invention.

A computer-readable memory comprising instructions that cause, when the program is executed by the computer, that the computer executes the method according to the invention.

### Advantageous effects of the invention

The use of the method according to the invention accelerates the process of mounting through-hole electronic elements on PCBs. It will be also possible to automatize the process by changing the manual forming and mounting operations into an automated process with the use of a robotic arm. Moreover, forming is effected in a machine when feeding elements, and not in a separate process, and this also facilitates and speeds-up the process. Additionally, it is possible to use the subject method for mounting elements in short batch production.

### Detailed description of an advantageous embodiment of the invention

A method of mounting, preferably through-hole electronic elements, on a PCB, according to the first preferable embodiment of the invention, is carried out with the use of an industrial robot. Industrial robot is preferably provided with a robotic arm with a force and/or moment sensor attached thereto, and a tool changer to which a gripper with fingers is attached. In an embodiment, rod feeders, radial feeders or tray feeders are used, but a person skilled in the art will be aware that any mechanical solution may be used that enables raising and mounting elements.

In a preferable embodiment the force and/or moment sensor is of a six-axes type and to the control system feedback is provided in a form of forces that are applied to the element being mounted in any of the six axes. The use of the force and/or moment sensor makes it possible to simulate the sense of touch used by a human being (operator) when mounting the same elements manually.

Gripper and movable fingers are intended for gripping an element to be embedded. According to the shape, the gripper fingers adjust to the thickness of the component and thereby ensure proper clamping thereof to prevent slipping of the element from the robot gripper.

Data loading and operation of the machine is carried out with the use of an HMI (Human-Machine Interface) operator panel, provided with a PLC controller positioned on the machine panel. It makes it possible for the user to visualize and preform the following operations:
- basing of the machine
- loading, change or interruption of mounting command,
- preview of the status of the accessories the machine is provided with,
- preview of the service menu (e.g., manual control, preview of signals)
- preview and cancelling alarms,
- preview of the screen with basic data on the mounting in progress,
- preview of the screen with basic statistics of the machine.
- user authentication at two levels according to the capabilities conferred to him/her,
- easy change of the language (PL, EN) for the entire visualization.

Process program generator is easy and intuitive and does not require specialist programming knowledge. For generating mounting sequences Pick&place data are used that are commonly used also in other machines. This enables the operator quick introduction or editing of mounting sequences for new or already existing products. For example, addition of four additional elements into a mounting sequence is possible within less than 10 minutes. The software is based on a cloud-operating application.

Monitoring software further enables both preview (in time) of such parameters as: mounting effectiveness, machine use rate, partial mounting duration time, PCBs flow duration time, number of mounted PCBs, number of mounted components, currently processed command, machine status, alarms set on the device, machine configuration.

The first step in the component mounting process comprises generating a mounting recipe with the use of the mentioned application. Programming is fast and easy, it enables building of a program for mounting over a dozen of elements within less than 30 minutes. Then a next product enters the machine. Loading of a mounting recipe for a specific product is carried out.

A further step is performing of calibration process. Calibration functions are aimed at levelling the impact of the rigidity degree of the PCB at a given point where the selected THT component is to be embedded. This process is recalled once for each new component to be mounted on a given PCB on a given machine.

In performing calibration process the robot arm grabs a component and transports it to a predetermined position with intentionally imposed X-axis and Y-axis offsets to prevent the component from entering mounting openings. When the robot arm reaches the predetermined position, taring of the force and/or moment sensor is carried out and tri-state Z-axis adjustment is performed until Fz force becomes stabilized within a preset range, which is interpreted by the algorithm as component introductory portion abutting the surface of PCB. Then the Z-axis starting position is recorded which position means detection of the appropriate component height. A further process step comprises selecting parameters of the regulator the latter being afterwards actuated with the determined parameters, the regulator output being transmitted as a Z-axis offset, while the X-axis and Y-axis offsets applied in the initial step being turned off. The positions of the X-axis and Y-axis are recorded for the Z-axis offset, if the Z offset calculated by the regulator is greater than or equal to a preset percent value, and passing to step of mounting the element on the PCB is initiated. If the Z offset calculated by the regulator is less than a preset percentage (depending on the rigidity of the PCB) of the length of the component leg (situation interpreted by the algorithm as the component abutting the surface of the PCB), the opening search algorithm is actuated (regulator, preferably a PLC controller, transfers the X and Y axes offsets to the robot to make the robot drive following a square spiral when searching for openings). At the moment when excessive values for the forces Fx and Fy (interpreted as the component legs abutting the opening edge) are stated interruption of the robot program is activated (the robot arrests its motion), an X-axis and Y-axis compensation mechanism is activated (retracting the robot at a predetermined position to make the forces drop below limits), and the spiral movement direction is changed. Additionally, the robot corrects the Z-axis twist (if the Z-axis force moment exceeds preset limits).

It should be noted that throughout the specification designations X, Y and Z for the forces and axes are defined relative to the board on which an element is being mounted. Z direction is a direction perpendicular to the board and X and Y directions are directions which are perpendicular to each other and parallel to the board.

In a preferable embodiment, selection of the regulator parameters is performed by Ziegler/Nichols oscillation method, and the regulator parameters are proportional, integrating and differentiating portion setups.

In an embodiment, opening search process consists on moving of the component if the Z-axis offset is less than a preset parameter, along a predetermined path, preferably in a shape of a square spiral, beginning from the current position point. When the force and/or moment sensor detects an opening edge in the board, the movement of the component is arrested. The component is moved away from the opening edge based on the data from the force and/or moment sensor. If a preset maximum duration time or opening search area have not been exceeded, the component movement direction is changed and the opening search procedure is repeated. If the maximum duration time or the opening search area is exceeded, the procedure is terminated with a negative effect and it needs to be repeated.

The moment when an opening edge is detected occurs as appearance of a value of the force resultant from Fx and Fy forces above a maximum horizontal force. Additionally, at the moment when an opening edge is detected the component is moved away according to the direction of the force resultant from Fx and Fy forces to bring the value of the force resultant from Fx and Fy forces to a value below a preset minimal horizontal force value.

Upon calibration of the device for mounting a given component on a specific board, elements are mounted on the board. Element is grabbed by the gripper fingers of the robot arm, and next the component is transported to a predetermined starting position. When it reaches the predetermined starting position, the force and/or moment sensor is subject to taring. When the sensor is tared, the component is moved in the direction of the Z-axis, i.e. its height over the surface of the board is decreased, until the component contacts the board surface. At the moment when the board is contacted by the component, the regulator with determined parameters is activated, and the preset pressing force of the component is constant and it is about 30% of the preset value. This value is an experimental value and a person skilled in the art will be aware how, based on routine measurements, this value should be established. A further step comprises transmitting from the regulator, when the output data are stabilized, of a signal to means for gripping and transporting the industrial robot as a Z-axis offset. The component is released from the means for gripping and transporting the industrial robot, if the Z-axis offset is greater than or equal to a preset parameter and the current position of the component is established as the starting point. On the other hand, if the Z-axis offset is less than the preset parameter, then the component is moved along a part in a shape of a spiral, preferably a square spiral, beginning from the current position point. When the force and/or moment sensor detects an opening edge, then the movement of the component is arrested. The component is moved away from the opening edge based on the data from the force and/or moment sensor. Then the process of moving the component along the path in the shape of a spiral is assumed again if the maximum duration time or opening search area are not exceeded, and then a change in the movement direction is made.

When the element becomes embedded, a further element is taken and the whole process is repeated. The step of embedding further elements is repeated until all the components according to the recipe are mounted.

The depth at which a component is embedded within the board is calculated based on the rigidity of the board and the element insertion length, the component being positioned in one or more openings.

A method of mounting according to a further preferable embodiment enables embedding elements that require preforming, since preforming is executed on a machine during feeding elements, and not in a separate process.

Moreover, in the case of a change of the element to be embedded, resetting of the machine takes less than 1 minute and no change in feeders is necessary.

According to another preferable embodiment, the components are terminated in metallic legs. When mounting, the legs are inserted into openings.

## Claims

1. A method for mounting, suitable for positioning through-hole component on a printed circuit board PCB, by means of an industrial robot that comprises a force and/or moment sensor and means for gripping and transporting a component, comprising the steps of:
a. grabbing a component,
b. transporting the component to a predetermined starting position,
c. taring the force and/or moment sensor,
d. transporting the component in the Z-axis, defined as a height over the surface of the board, in the direction of the board, until the component contacts the board surface,
e. actuating a regulator with determined parameters,
f. transmitting from the regulator, when output data are stabilized, of a signal to means for gripping and transporting of the industrial robot as Z-axis offset, if the Z-axis offset is greater than or equal to a preset parameter
g. releasing the component from the means for gripping and transporting of the industrial robot and establishing the current position of the component as a starting point,
if the Z-axis offset is less than a preset parameter
h. moving the component along a predetermined path, beginning from the current position point,
i. arresting the movement of the component, when the force sensor and/or the moment sensor detect an opening edge in the board,
j. moving the component away from the opening edge based on data from the force and/or moment sensor,
k. repeating steps g.-j, while a change in the component movement is executed, **characterised in that** if the Z-axis offset is less than a preset parameter
the moment when an opening edge is detected occurs as appearance of a value of the force resultant from Fx and Fy forces above a preset maximum horizontal force,
wherein at the moment when an opening edge is detected the component is moved away in step j according to the direction of the force resultant from Fx and Fy forces to bring the value of the force resultant from Fx and Fy forces to a value below a preset minimum horizontal force value.

2. Method according to claim 1, **characterized in that** step k is carried out if a predetermined maximum duration time or opening search area are not exceeded.

3. Method according to claim 1 or 2, **characterized in that** before step a the following steps are carried out:
m. transporting the component to a predetermined position with intentionally imposed X-axis and Y-axis offsets so as to prevent the component enter mounting openings,
n. taring the force and/or moment sensor,
o. tri-state Z-axis adjustment until Fz force is stabilized within a preset range,
p. recording the Z-axis starting position which position means detection of appropriate component height,
r. selecting regulator parameters,
s. activating the regulator with determined parameters, the regulator output being transmitted as a Z-axis offset, and the X-axis and Y-axis offsets applied in the initial step being turned off,
t. recording X-axis and Y-axis positions and Z-axis offset, if the Z offset calculated by the regulator is greater or equal to a preset percent value, and passing to step a according to claim. 1
u. activating opening search algorithm if the Z offset calculated by the regulator is less than the present percent value,
wherein the opening search algorithm comprises the steps of:
u1. moving the component, if the Z-axis offset is less than a preset parameter, along a predetermined path, beginning form the current position point.
u2. arresting the movement of the component, when the force sensor and/or the moment sensor detect an opening edge in the board,
u3. moving the component away from the opening edge based on data from the force and/or moment sensor,
u4. changing the component movement direction and repeating steps u1-u4.

4. Method according to any one of claims 1-3, **characterized in that** step u4 is carried out if a predetermined maximum duration time or opening search area are not exceeded, steps m-u are repeated.

5. Method according to any one of claims 1-4, **characterized in that** the regulator parameters are proportional, integrating and differentiating portions setups.

6. Method according to any one of claims 1-5, **characterized in that** selecting of the regulator parameters in step r is performed by Ziegler/Nichols oscillation method.

7. Method according to any one of claims 1-6, **characterized in that** the predetermined path along which the component is moving has a shape of a spiral, preferably a square spiral.

8. Method according to any one of claims 1-7, **characterized in that** the depth at which the component is embedded within the board is calculated based on the rigidity of the board and the element insertion length.

9. Method according to any one of claims 1-8, **characterized in that** the component is placed in a greater number of openings.

10. Computer program comprising instructions which cause, when the program is executed by a computer, the computer configured to control an industrial robot that comprises a force and/or moment sensor and means for gripping and transporting a component to carry out the method steps according to claims 1-9.

11. Computer-readable memory comprising instructions which cause, when the program is executed by a computer, the computer configured to control to control an industrial robot that comprises a force and/or moment sensor and means for gripping and transporting a component to carry out the method steps according to claims 1-9.

## Patentansprüche

1. Verfahren zur Montage, geeignet zur Positionierung von Durchgangsbohrungsbauteilen auf einer gedruckten Leiterplatte (PCB), mittels eines Industrieroboters, der einen Kraft- und/oder Momentensensor und Greif- und Transportmittel eines Bauteils aufweist, dass folgende Schritte umfasst:
a. Ergreifen eines Bauteils,
b. Transportieren des Bauteils zu einer vorbestimmten Ausgangsposition,
c. Tarieren des Kraft- und/oder Momentensensors,
d. Transportieren des Bauteils in der Z-Achse, definiert als eine Höhe über der Oberfläche der Leiterplatte, in Richtung der Leiterplatte, bis das Bauteil die Leiterplatteoberfläche berührt,
e. Ansteuerung eines Reglers mit bestimmten Parametern,
f. Übermittlung eines Signals vom Regler, wenn die Ausgangsdaten stabilisiert sind, an die Greif- und Transportmittel des Industrieroboters als Z-Achsenversatz, wenn der Z-Achsenversatz größer oder gleich einem vorgegebenen Parameter ist,
g. Lösen des Bauteils von der Greif- und Transportmittel des Industrieroboters und Festlegen der aktuellen Position des Bauteils als Startpunkt, wenn der Z-Achsen-Versatz kleiner als ein vorgegebener Parameter ist,
h. Bewegen des Bauteils entlang einer vorgegebenen Bahn, ausgehend vom aktuellen Positionspunkt,
i. Anhalten der Bewegung des Bauteils, wenn der Kraftsensor und/oder der Momentensensor eine Öffnungskante in der Leiterplatte erkennt,
j. Bewegen des Bauteils von der Öffnungskante weg, basierend auf den Daten des Kraft- und/oder Momentensensors,
k. Wiederholung der Schritte g.-j., während eine Änderung der Bauteilbewegung ausgeführt wird,
**dadurch gekennzeichnet, dass**
wenn der Z-Achsenversatz kleiner als ein voreingestellter Parameter ist, der Moment, in dem eine Öffnungskante detektiert wird, als Auftreten eines Wertes der aus den Fx- und Fy-Kräften resultierenden Kraft oberhalb einer voreingestellten maximalen horizontalen Kraft auftritt,
wobei in dem Moment, in dem eine Öffnungskante detektiert wird, das Bauteil im Schritt j entsprechend der Richtung der aus Fx- und Fy-Kräften resultierenden Kraft wegbewegt wird, um den Wert der aus Fx- und Fy-Kräften resultierenden Kraft auf einen Wert unterhalb eines voreingestellten minimalen Horizontalkraftwertes zu bringen.

2. Verfahren nach Anspruch 1, **dadurch gekennzeichnet, dass** der Schritt k durchgeführt wird, wenn eine vorgegebene maximale Zeitdauer oder ein vorgegebener Öffnungssuchbereich nicht überschritten wird.

3. Verfahren nach Anspruch 1 oder 2, **dadurch gekennzeichnet, dass** vor Schritt a die folgenden Schritte durchgeführt werden:
m. Transportieren des Bauteils in eine vorgegebene Position mit absichtlich auferlegten X-Achsen- und Y-Achsen-Versätzen, um zu verhindern, dass das Bauteil in Montageöffnungen eintritt,
n. Tarierung des Kraft- und/oder Momentensensors,
o. dreistufige Einstellung der Z-Achse, bis die Fz-Kraft innerhalb eines vorgegebenen Bereichs stabilisiert ist,
p. Aufzeichnung der Ausgangsposition der Z-Achse, d. h. der Position, an der die geeignete Bauteilhöhe ermittelt wird,
r. Auswahl der Parameter des Reglers,
s. Aktivierung des Reglers mit den festgelegten Parametern, wobei der Ausgang des Reglers als Z-Achsen-Versatz übertragen wird und die im ersten Schritt angewendeten Versätze für die X-Achse und die Y-Achse ausgeschaltet werden,
t. Aufzeichnung der Positionen der X- und Y-Achse und des Z-Achsen-Versatzes, wenn der vom Regler berechnete Z-Versatz größer oder gleich einem vorgegebenen Prozentwert ist, und Übergang zu Schritt a gemäß Patentanspruch. 1
u. Aktivieren des Öffnungssuchalgorithmus, wenn der vom Regler berechnete Z-Versatz kleiner als der vorliegende Prozentwert ist,
wobei der Öffnungssuchalgorithmus die folgenden Schritte umfasst:
u1. Bewegen des Bauteils, wenn der Z-Achsenversatz kleiner als ein voreingestellter Parameter ist, entlang eines vorbestimmten Pfades, beginnend vom aktuellen Positionspunkt.
u2. Anhalten der Bewegung des Bauteils, wenn der Kraftsensor und/oder der Momentensensor eine Öffnungskante in der Leiterplatte erkennt,
u3. Bewegen des Bauteils von der Öffnungskante weg, basierend auf den Daten des Kraft- und/oder Momentensensors,
u4. Ändern der Bewegungsrichtung des Bauteils und Wiederholen der Schritte u1-u4.

4. Verfahren nach einem der Ansprüche 1-3, **dadurch gekennzeichnet, dass** Schritt u4 durchgeführt wird, wenn eine vorgegebene maximale Zeitdauer oder ein vorgegebener Öffnungssuchbereich nicht überschritten wird, die Schritte m-u werden wiederholt.

5. Verfahren nach einem der Ansprüche 1-4, **dadurch gekennzeichnet, dass** die Reglerparameter proportionale, integrierende und differenzierende Anteilseinstellungen sind.

6. Verfahren nach einem der Ansprüche 1-5, **dadurch gekennzeichnet, dass** die Auswahl der Reglerparameter in Schritt r durch das Ziegler/Nichols-Oszillationsverfahren erfolgt.

7. Verfahren nach einem der Ansprüche 1-6, **dadurch gekennzeichnet, dass** die vorgegebene Bahn, entlang der sich das Bauteil bewegt, die Form einer Spirale, vorzugsweise einer quadratischen Spirale, aufweist.

8. Verfahren nach einem der Ansprüche 1-7, **dadurch gekennzeichnet, dass** die Tiefe, in der das Bauteil in die Leiterplatte eingebettet wird, auf der Grundlage der Steifigkeit der Leiterplatte und der Elementeinbaulänge berechnet wird.

9. Verfahren nach einem der Ansprüche 1-8, **dadurch gekennzeichnet, dass** das Bauteil in einer größeren Anzahl von Öffnungen platziert wird.

10. Computerprogramm mit Befehlen, die, wenn das Programm von einem Computer ausgeführt wird, bewirken, dass der Computer so konfiguriert ist, dass er einen Industrieroboter steuert, der einen Kraft- und/oder Momentensensor und Greif- und Transportmittel eines Bauteils umfasst, um die Verfahrensschritte nach den Ansprüchen 1-9 auszuführen.

11. Computerlesbarer Speicher mit Befehlen, die, wenn das Programm von einem Computer ausgeführt wird, bewirken, dass der Computer so konfiguriert ist, dass er einen Industrieroboter steuert, der einen Kraft- und/oder Momentensensor und Greif- und Transportmittel eines Bauteils umfasst, um die Verfahrensschritte nach den Ansprüchen 1-9 auszuführen.

## Revendications

1. Un procédé de montage, adapté au positionnement d'un composant à trou traversant sur une carte de circuit imprimé PCB, au moyen d'un robot industriel qui comprend un capteur de force et/ou de moment et des moyens pour saisir et transporter un composant, comprenant les étapes suivantes :
a. saisie d'un composant,
b. transport du composant jusqu'à une position de départ prédéterminée, t,
c. tarage du capteur de force et/ou de moment,
d. transport du composant dans l'axe Z, défini comme une hauteur au-dessus de la surface de la carte, dans la direction de la carte, jusqu'à ce que le composant entre en contact avec la surface de la carte,
e. actionnement d'un régulateur avec des paramètres déterminés,
f. transmission par le régulateur, lorsque les données de sortie sont stabilisées, d'un signal aux moyens de préhension et de transport du robot industriel en tant que décalage de l'axe Z, si le décalage de l'axe Z est supérieur ou égal à un paramètre prédéfini,
g. libération du composant à partir des moyens de préhension et transport du robot industriel et établissement de la position actuelle du composant comme point de départ, si le décalage de l'axe Z est inférieur à un paramètre prédéfini,
h. déplacement du composant le long d'une trajectoire prédéterminée, à partir du point de position actuel,
i. arrêt du mouvement du composant, lorsque le capteur de force et/ou le capteur de moment détectent un bord d'ouverture dans la carte,
j. éloignement du composant du bord d'ouverture sur la base des données provenant du capteur de force et/ou de moment,
k. répétition des étapes g.-j, tandis qu'une modification du mouvement du composant est exécutée,
**caractérisé en ce que**
si le décalage de l'axe Z est inférieur à un paramètre prédéfini, le moment où un bord d'ouverture est détecté se produit comme apparition d'une valeur de la résultante des forces Fx et Fy supérieure à une force horizontale maximale prédéfinie,
dans lequel, au moment où un bord d'ouverture est détecté, le composant est éloigné à l'étape j selon la direction de la résultante des forces Fx et Fy pour amener la valeur de la résultante des forces Fx et Fy à une valeur inférieure à une valeur de force horizontale minimale prédéfinie.

2. Le procédé selon la revendication 1, **caractérisé en ce que** l'étape k est effectuée si une durée maximale prédéterminée ou une zone de recherche d'ouverture ne sont pas dépassées.

3. Le procédé selon la revendication 1 ou 2, **caractérisé en ce qu'**avant l'étape, les étapes suivantes sont effectuées :
m.transport du composant jusqu'à une position prédéterminée avec des décalages de l'axe X et de l'axe Y imposés intentionnellement afin d'empêcher le composant de pénétrer dans les ouvertures de montage,
n. tarage du capteur de force et/ou de moment,
o. réglage de l'axe Z à trois états jusqu'à ce que la force Fz soit stabilisée dans une plage prédéfinie,
p. enregistrement de la position de départ de l'axe Z, qui permet de détecter la hauteur appropriée du composant,
r. sélection des paramètres du régulateur,
s. activation du régulateur avec des paramètres déterminés, la sortie du régulateur étant transmise comme un décalage de l'axe Z, et les décalages de l'axe X et de l'axe Y appliqués lors de l'étape initiale étant désactivés,
t. enregistrement des positions de l'axe X et de l'axe Y et du décalage de l'axe Z, si le décalage Z calculé par le régulateur est supérieur ou égal à une valeur prédéfinie en pourcentage, et passage à l'étape a selon la revendication 1
u. activation de l'algorithme de recherche d'ouverture si le décalage Z calculé par le régulateur est inférieur à la valeur actuelle en pourcentage,
dans lequel l'algorithme de recherche d'ouverture comprend les étapes suivantes :
u1. déplacement du composant, si le décalage de l'axe Z est inférieur à un paramètre prédéfini, le long d'une trajectoire prédéterminée, à partir du point de position actuel,
u2. arrêt du mouvement du composant, lorsque le capteur de force et/ou le capteur de moment détectent un bord d'ouverture dans la carte,
u3. éloignement du composant du bord d'ouverture sur la base des données provenant du capteur de force et/ou de moment,
u4. modification de la direction du mouvement du composant et répétition des étapes u1-u4.

4. Le procédé selon l'une quelconque des revendications 1 à 3, **caractérisé en ce que** l'étape u4 est effectuée si une durée maximale prédéterminée ou une zone de recherche d'ouverture ne sont pas dépassées, les étapes m-u sont répétées.

5. Le procédé selon l'une quelconque des revendications 1 à 4, **caractérisé en ce que** les paramètres du régulateur sont des configurations de portions proportionnelles, intégrantes et différenciantes.

6. Le procédé selon l'une quelconque des revendications 1 à 5, **caractérisé en ce que** la sélection des paramètres du régulateur à l'étape r est effectuée par la méthode d'oscillation Ziegler/Nichols.

7. Le procédé selon l'une quelconque des revendications 1 à 6, **caractérisé en ce que** la trajectoire prédéterminée le long de laquelle le composant se déplace a la forme d'une spirale, de préférence d'une spirale carrée.

8. Le procédé selon l'une quelconque des revendications 1 à 7, **caractérisé en ce que** la profondeur à laquelle le composant est incorporé dans la carte est calculée sur la base de la rigidité de la carte et de la longueur d'insertion des éléments.

9. Le procédé selon l'une quelconque des revendications 1 à 8, **caractérisé en ce que** le composant est placé dans un plus grand nombre d'ouvertures.

10. Un programme informatique comprenant des instructions qui font que, lorsque le programme est exécuté par un ordinateur, l'ordinateur configuré pour commander un robot industriel qui comprend un capteur de force et/ou de moment et des moyens de préhension et de transport d'un composant, exécute les étapes du procédé selon les revendications 1 à 9.

11. Une mémoire lisible par ordinateur comprenant des instructions qui font que, lorsque le programme est exécuté par un ordinateur, l'ordinateur configuré pour commander un robot industriel qui comprend un capteur de force et/ou de moment et des moyens de préhension et de transport d'un composant, exécute les étapes du procédé selon les revendications 1 à 9.
